# EUROPÄISCHE PATENTSCHRIFT

(11) **EP 0 962 946 B1**
(45) Veröffentlichungstag und Bekanntmachung des Hinweises auf die Patenterteilung: **11.08.2004**
(21) Anmeldenummer: 99890134.2
(22) Anmeldetag: 28.04.1999
(51) Int. Cl.: H01F 17/02, H01F 17/04, H01F 27/29, H01F 27/02

(54) **Spule zur stehenden Montage auf Schaltungsträgern**
Standing mounted coil for printed circuit boards
Bobine de montage verticale pour cartes à circuit imprimé

(30) Priorität: 04.06.1998 AT 96598
(43) Veröffentlichungstag der Anmeldung: 08.12.1999
(73) Patentinhaber: Siemens Aktiengesellschaft Österreich, 1210 Wien (AT)
(72) Erfinder: Reischer, Wilhelm, 1210 Wien (AT)
(74) Vertreter: Matschnig, Franz, Dipl.-Ing.

(56) Entgegenhaltungen:
- DE-A- 2 229 859
- DE-A- 3 822 627
- US-A- 3 548 356
- US-A- 4 754 250
- PATENT ABSTRACTS OF JAPAN vol. 1998, no. 06, 30. April 1998 (1998-04-30) & JP 10 050525 A (TOKIN CORP), 20. Februar 1998 (1998-02-20)

## Beschreibung

Die Erfindung bezieht sich auf eine Spule zur stehenden Montage auf Schaltungsträgern, wie z. B. auf Leiterplatten, wobei von dem oberen und dem unteren Ende der Spulenwicklung je ein Anschlussdraht im wesentlichen parallel zur Spulenachse nach unten geführt ist und die Enden beider Anschlussdrähte über das untere Spulenende vorstehen.

Induktive Bauelemente wie Spulen oder Luftdrosseln, Spulen mit Stabkernen etc. werden beispielsweise in Stromversorgungsgeräten, z. B. Schaltwandlern häufig verwendet. Dabei kommt vielfach eine stehende Montage auf Leiterplatten zur Anwendung, da sich hierdurch gegenüber der liegenden Montage eine Einsparung an Leiterplattenfläche ergibt.

Der untere, d. h. jener der Leiterplatte zugewandte Anschlussdraht verläuft dabei direkt von der Wicklung, üblicherweise einstückig, parallel zur Spulenachse nach unten, wogegen der Anschlussdraht für das obere Spulenende zunächst etwas nach außen und dann parallel zur Spulenachse, außerhalb der Spule gleichfalls nach unten verläuft. Beide Anschlußdrähte stehen ein wenig über das untere Spulenende vor, sodass sie in vorbereitete Bohrungen einer Leiterplatte gesteckt und letztlich mit Leiterbahnen verlötet werden können. Die Bezeichnung "unten" ist in dieser Beschreibung nicht im engeren Sinn zu verstehen, sondern bedeutet immer "dem Schaltungsträger zugewandt". Zur Induktivitätserhöhung wird häufig ein ferromagnetischer Stabkern in den zylindrischen Innenraum der Spule gesteckt und dann mit Hilfe eines Schmelzklebers oder dergleichen fixiert.

Die Verwendung stehender Luftspulen in der bekannten Ausführung bringt den Nachteil mit sich, dass von außen einwirkende Kräfte, wie sie z. B. bei Rüttelbeanspruchungen auftreten, zu einer Verformung der Spulenwicklung führen können. Die Folge ist eine Änderung des Induktivitätswertes und/oder ein Unterschreiten von Sicherheitsabständen zu anderen Bauelementen, sodass beispielsweise Kriechströme oder Überschläge auftreten können. Bei Verwendung von Stabkernen kann die mechanische Stabilität durch das erwähnte Verkleben verbessert werden.

Aus der US 4 725 449 A geht eine HF-Spule für die Erzeugung eines Plasmas hervor, die innerhalb einer Plasmakammer angeordnet ist. Die Spule ist aus Kupferrohr aufgebaut, mit einer Zwischenschicht aus einem organischen Binder und einer Außenschicht aus einer Glasmasse, um eine Isolierschicht mit einer Durchbruchsfestigkeit in der Größenordnung von 5 kV zu erhalten.

In der DE 37 21 759 A1 ist die Befestigung eines Transformators auf einer Leiterplatte beschrieben, wobei Transformatorwicklungen unmittelbar auf der Leiterplatte als Leiterbahnen aufgebracht sind. In ähnlicher Weise sind gemäß der EP 0 134 950 A2 Leiterbahnen der Trägerplatine eines Übertragers als Übertragerwicklungen ausgebildet.

Die WO 97/33 185 offenbart eine zweiteilige Sattelspule für NMR-Anwendungen, wobei zwei Spulenhälften mechanisch und elektrisch miteinander verbunden und die Anschlußdrähte senkrecht zu den Achsen der beiden Spulenhälften herausgeführt sind. Dadurch soll der Einfluß der Zuleitungen auf die Feldhomogenität verringert und die Auflösung des NMR-Spektrometers erhöht werden.

Die EP 0 257 738 A2 beschreibt die Befestigung und Verdrahtung einer Ringkernspule auf einer Leiterplatte, wobei Gegenstand des Dokumentes das Kreuzen von Leiterbahnen unterhalb der Ringkernspule ist.

In der GB 1 246 057 A wird eine Dünnfilmschaltung auf einer Polyamidfolie beschreiben, wobei diese Folie um ein zylindrisches Basisgehäuse gewickelt ist und Kontaktflächen mit nach unten ragenden Anschlußdrähten des Gehäuses in Verbindung stehen.

Die JP 9-180928 beschreibt eine Luftspule zur stehenden Montage auf einem Schaltungsträger, deren oberes Spulenende im Inneren der Spule zu dem Schaltungsträger geführt ist. In der hier offenbarten Spule ist kein ferromagnetischer Kern zur Erhöhung der Induktivität vorgesehen.

Die US 3 548 356 A beschreibt eine Spule deren oberes Spulenende innerhalb oder außerhalb der Spule zu einer Leiterplatte geführt ist, an der sie mit ihren beiden Enden befestigt ist. Gemäß der dort beschriebenen Ausführungsform ist der Anschlussdraht des oberen Spulenendes bauartbedingt in einer U-förmigen Ausnehmung in der Innenwand des Spulenkörpers im Spuleninneren nach unten geführt.

Es ist eine Aufgabe der Erfindung, eine Spule zur stehenden Montage zu schaffen, die eine verbesserte Stabilität aufweist, bzw. die keine zusätzlichen Fixierungsschritte, wie z. B. die Anwendung eines Heißklebers bei der Montage erfordert.

Diese Aufgabe wird mit einer Spule der eingangs erwähnten Art dadurch gelöst, dass der Anschlussdraht für das obere Spulenende im Spuleninneren längs der Spulenachse nach unten geführt ist und die Spule einen rohrförmigen Spulenkörper für die Spulenwicklung aus einem ferromagnetischen Material aufweist.

Durch diese Rückführung des Anschlussdrahtes im Inneren der Spule ergibt sich nicht nur die angestrebte Stabilität, sondern ganz allgemein ein kompakterer Aufbau, der auch zu einer Platzersparnis auf der Leiterplatte führt. Von besonderer Bedeutung ist hierbei, dass der Anschlussdraht für das obere Spulenende im wesentlichen längs der Spulenachse nach unten geführt ist. Von der Rotationssymmetrie abgesehen ergibt sich hier der maximal mögliche Abstand des Anschlussdrahtes von den übrigen Spulenbereichen. Eine besondere Erhöhung der mechanischen Stabilität lässt sich dadurch erzielen, dass sie einen rohrförmigen Spulenkörper für die Spulenwicklung aufweist. Zur Erhöhung der Induktivität ist es vorgesehen, dass der Spulenkörper aus einem ferromagnetischen Material besteht. Dabei kann je nach den Anforderungen an Güte, Frequenzbereich etc. auf einen der vielen bekannten ferromagnetischen Werkstoffe zurückgegriffen werden. Der Spulenkörper kann auch erst im Zuge der Bestückung des Schaltungsträgers in die Spule eingeschoben werden, was sich günstig auf die Herstellungskosten auswirkt.

Falls der Anschlussdraht für das obere Spulenende eine über dieses Ende nach oben ragende Schleife aufweist, ergibt sich der Vorteil, dass es zu einer Kraftumlenkung der Befestigungskraft von dem Anschlussdraht senkrecht auf die Spulenwicklung kommt, wodurch diese vorgespannt und mechanisch stabilisiert wird.

Von Vorteil für die angestrebte Stabilität in mechanischer und elektrischer Hinsicht ist es, wenn der Spulenkörper mit Hilfe des Anschlussdrahtes für das obere Spulenende gegen den Schaltungsträger gehalten ist. Überdies können dann zusätzliche Befestigungsmaßnahmen entfallen.

Zur weiteren Erhöhung der mechanischen Stabilität ist es zweckdienlich, wenn die Spulenwicklung von einer äußeren Hülle umgeben ist. Dadurch ist auch ein mechanischer Schutz der Spulenwicklung gegeben.

Bei einer in der Praxis besonders zweckmäßigen Weitergestaltung ist die äußere Hülle als Schrumpfschlauch ausgebildet. Diese Lösung ist hinsichtlich der Material- und Montagekosten ratsam.

Wenn die äußere Hülle aus elektrisch isolierendem Material besteht, ist auch eine Isolation gegenüber der Umgebung gewährleistet.

Im Sinne einer guten mechanischen Festigkeit kann es ratsam sein, wenn sie auf einen auf dem Schaltungsträger befestigtem Hohldorn aufsteckbar ist. Der Durchmesser des Hohldorns ist dann dem Innendurchmesser des Spulenkörpers angepaßt.

Schließlich ist es für eine definierte und stabile Lage des Anschlussdrahtes für das obere Spulenende vorteilhaft, falls der Anschlussdraht für das obere Spulenende im wesentlichen formschlüssig in der Längsbohrung des Spulenkörpers aufgenommen ist.

Die Erfindung samt weiterer Vorteile ist im folgenden anhand beispielsweiser Ausführungsformen veranschaulicht, die in der Zeichnung dargestellt sind. In dieser zeigen.
- Fig. 1: in Seitenansicht bzw. teilweise geschnitten eine Spule nach er Erfindung in einer ersten Ausführungsform auf eine Leiterplatte aufgesetzt,
- Fig. 2: entsprechend Fig. 1 eine zweite Ausführungsform der Erfindung mit einem Spulenkörper und einer äußeren Hülle,
- Fig. 3: eine Ausführung wie Fig. 2, bei welcher die äußere Hülle ein Schrumpfschlauch ist, und
- Fig. 4: eine vierte Ausführungsform der Erfindung mit einem auf einer Leiterplatte befestigten Hohldorn für die Spule.

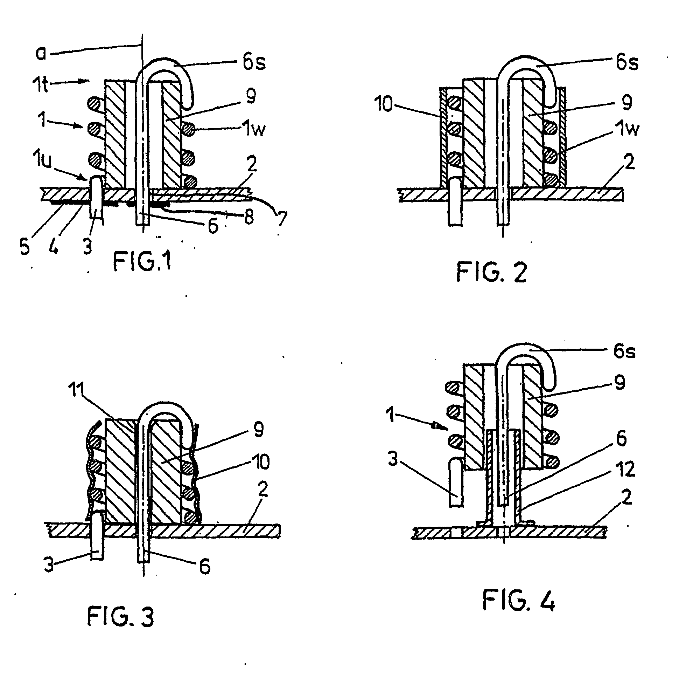

Fig. 1 zeigt eine Spule 1, die auf einem Schaltungsträger, wie einer Leiterplatte 2, montiert werden soll. Von dem unteren Spulenende lu ist ein Anschlussdraht 3 nach unten geführt, sodass er, über das untere Spulenende lu ein kurzes Stück vorstehend, durch eine vorbereitete Bohrung 4 der Leiterplatte 2 gesteckt und später mit einer Leiterbahn 5 verlötet werden kann.

Ein Anschlussdraht 6 für das obere Spulenende 1t ist bis zur Spulenachse a und sodann, rechtwinkelig abgebogen, längs dieser Achse im Spuleninneren nach unten geführt, wobei auch dieser Anschlussdraht 6 ein kurzes Stück über das untere Spulenende lu vorsteht und durch eine Bohrung 7 der Leiterplatte 2 gesteckt und mit einer Leiterbahn 8 verlötet werden kann.

Es ist leicht ersichtlich, dass die Lösung nach der Erfindung weniger Bauraum beansprucht, als die dem Stand der Technik entsprechenden darüber hinaus wird jedoch auch die Stabilität der Spulenkonstruktion erhöht, und es ergeben sich definierte und reduzierte Werte der Wicklungskapazität.

Der Anschlussdraht 6 weist für das obere Spulenende 1t eine über dieses Ende nach oben ragende Schlaufe 6s auf, welche zur weiteren Erhöhung der Stabilität beiträgt.

Zur weiteren Verbesserung der Stabilität ist ein rohrförmiger Spulenkörper 9 vorgesehen, der von der Spulenwicklung 1w umschlossen wird. Der Spulenkörper 9 besteht zur Erhöhung der Induktivität aus einem ferromagnetischen Material, wobei sich eine zusätzliche Induktivitätserhöhung dadurch ergibt, dass der Anschlussdraht 6 für das untere Spulenende durch das Kernloch des ferromagnetischen Spulenkörpers 9 geführt ist. Der Spulenkörper 9 kann auch erst bei der Montage der Spule 1 in deren Inneres geschoben werden. In montiertem Zustand hält der Anschlussdraht 6 bzw. die Schlaufe 6s den Spulenkörper 9 in definierter Lage gegen die Leiterplatte 2.

Die in Fig. 2 dargestellte Ausführungsform der Erfindung zeichnet sich dadurch aus, dass die Spulenwicklung 1w von einer äußeren Hülle 10 umgeben ist, welche vor allem stabilitätserhöhend wirkt und beispielsweise aus Kunststoff bestehen kann. Diese Hülle kann nach der Montage der Spule 1 auf diese aufgeschoben werden oder zusammen mit der Spule montiert werden. Gegebenenfalls kann diese Hülle 10 auch mit der Leiterplatte 2 fest verbunden sein oder verbunden werden. Falls die Hülle 10 auch magnetisch und/oder elektrisch schirmen soll, besteht sie aus einem ferromagnetischen und/oder elektrisch leitfähigen Werkstoff und die Hülle 10 kann gegebenenfalls auch oben geschlossen, d. h. topfförmig sein.

Wie Fig. 3 zeigt, kann die Hülle 10 auch ein Schrumpfschlauch sein, der insbesondere falls man einen Spulenkörper 9 verwendet, bereits vor der Montage auf der Leiterplatte 2 aufgeschrumpft werden kann. Die Ausführung nach Fig. 3 weist überdies einen Spulenkörper 9 auf, dessen Längsbohrung 11 so bemessen ist, dass sie den Anschlussdraht 6 für das untere Spulenende im wesentlichen formschlüssig in sich aufnimmt. Es versteht sich, dass sich dadurch eine definierte Lage dieses Anschlussdrahtes und eine hohe elektrische und mechanische Stabilität ergibt.

Es ist an dieser Stelle noch zu erwähnen, dass die Durchführung des Anschlussdrahtes für das obere Spulenende durch den rohrförmigen, ferromagnetischen Spulenkörper eine Serieninduktivität zur eigentlichen Wicklungsinduktivität der Spule, sowie zu deren Parallelkapazität ergibt. Da die Wicklungskapazität durch eine solche Serieninduktivität zumindest in einem gewissen Ausmaß unter höheren Frequenzen kompensiert wird, ergibt diese Verbesserung des Frequenzganges in manchen Anwendungsfällen nicht unerhebliche Vorteile.

Bei der Ausführung nach Fig. 4 ist auf der Leiterplatte 2 ein Hohldorn 12 befestigt, z. B. aufgelötet. Die Spule 1 samt Spulenkörper 9 wird zur Montage auf diesen Hohldorn 12 aufgeschoben und somit zusätzlich fixiert.

Wenngleich die Erfindung vorstehend in Zusammenhang mit einer Spule 1 beschrieben wurde, die lediglich zwei Anschlüsse - einen oberen und einen unteren - besitzt, sind auch Ausführungen denkbar, die Anzapfungen der Spule 1 aufweisen oder zwei gekoppelte Spulen besitzen.

## Patentansprüche

1. Spule (1) zur stehenden Montage auf Schaltungsträgern (2), wie z. B. auf Leiterplatten, wobei von dem oberen und dem unteren Ende der Spulenwicklung (1w) je ein Anschlussdraht (3, 6) im wesentlichen parallel zur Spulenachse (a) nach unten geführt ist und die Enden beider Anschlussdrähte über das untere Spulenende vorstehen, **dadurch gekennzeichnet, dass** der Anschlussdraht (6) für das obere Spulenende (1t) im Spuleninneren längs der Spulenachse (a) nach unten geführt ist und die Spule einen rohrförmigen Spulenkörper (9) für die Spulenwicklung (1w) aus einem ferromagnetischen Material aufweist.

2. Spule (1) nach Anspruch 1, **dadurch gekennzeichnet, dass** der Anschlussdraht (6) für das obere Spulenende (1t) eine über dieses Ende nach oben ragende Schleife (6s) aufweist.

3. Spule (1) nach einem der Ansprüche 1 oder 2,**dadurch gekennzeichnet, dass** der Spulenkörper (9) mit Hilfe des Anschlussdrahtes (6) für das obere Spulenende (1t) gegen den Schaltungsträger gehalten ist.

4. Spule (1) nach einem der Ansprüche 1 bis 3, **dadurch gekennzeichnet, dass** die Spulenwicklung (6) von einer äußeren Hülle (10) umgeben ist.

5. Spule (1) nach Anspruch 4, **dadurch gekennzeichnet, dass** die äußere Hülle (10) als Schrumpfschlauch ausgebildet ist.

6. Spule (1) nach einem der Ansprüche 4 oder 5, **dadurch gekennzeichnet, dass** die äußere Hülle (10) aus elektrisch isolierendem Material besteht.

7. Spule (1) nach einem der Ansprüche 1 bis 6 **dadurch gekennzeichnet, dass** sie auf einen auf dem Schaltungsträger (2) befestigten Hohldorn (12) aufsteckbar ist.

8. Spule (1) nach einem der Ansprüche 1 bis 7, **dadurch gekennzeichnet, dass** der Anschlussdraht (6) für das obere Spulenende (1t) im wesentlichen formschlüssig in der Längsbohrung (11) des Spulenkörpers (9) aufgenommen ist.

## Claims

1. A coil (1) for mounting vertically on circuit supporting means (2), such as a printed board, in which leads (3, 6) leading from the upper and lower ends of the coil winding (1w) extend downwardly substantially parallel to the coil axis (a) and the ends of the two leads protrude beyond the bottom end of the coil, **characterized in that** the lead (6) assigned to the upper coil end (1t) extends downwardly within the coil along the coil axis (a) and the coil winding (1w) surrounds a tubular coil former (9) fabricated from a ferromagnetic material.

2. A coil (1) as defined in claim 1, **characterized in that** said lead (6) assigned to said upper coil end (1t) has a loop (6) that extends upwardly beyond said upper coil end.

3. A coil (1) as defined in claim 1 or claim 2, **characterized in that** said coil former (9) is held against said circuit supporting means with the aid of said lead (6) assigned to said upper coil end (1t).

4. A coil (1) as defined in any one of claims 1 to 3, **characterized in that** said coil winding (6) is surrounded by an external shell (10).

5. A coil (1) as defined in claim 4, **characterized in that** said external shell (10) is in the form of a shrinkage tube.

6. A coil (1) as defined in claim 4 or claim 5, **characterized in that** said external shell (10) consists of electrically insulating material.

7. A coil (1) as defined in any one of claims 1 to 6, **characterized in that** said coil is adapted to be fitted over a hollow mandrel (12) mounted on said circuit supporting means (2).

8. A coil (1) as defined in any one of claims 1 to 7, **characterized in that** said lead (6) assigned to said upper coil end (1t) is accommodated in the longitudinal bore (11) of the core of said coil (9) with a substantially positive fit.

## Revendications

1. Bobine (1) à montage vertical sur des supports de circuits (2), comme par exemple des cartes de circuits imprimés, dans laquelle un fil de raccordement (3, 6) est conduit vers le bas, à partir de l'extrémité supérieure et de l'extrémité inférieure de l'enroulement de la bobine (1w), sensiblement parallèlement à l'axe de la bobine (a), et les extrémités des deux fils de raccordement sont saillantes hors de l'extrémité inférieure de la bobine, **caractérisée en ce que** le fil de raccordement (6) pour l'extrémité supérieure de la bobine (1t) est conduit vers le bas à l'intérieur de la bobine le long de l'axe de la bobine (a), et la bobine présente un corps de bobine tubulaire (9) pour l'enroulement de bobine (1w) en un matériau ferromagnétique.

2. Bobine (1) selon la revendication 1, **caractérisée en ce que** le fil de raccordement (6) pour l'extrémité supérieure de la bobine (1t) présente une boucle (6s) saillante vers le haut au-delà de cette extrémité.

3. Bobine (1) selon l'une quelconque des revendications 1 ou 2, **caractérisée en ce que** le corps de bobine (9) est maintenu contre le support de circuits à l'aide du fil de raccordement (6) pour l'extrémité supérieure de la bobine (1t).

4. Bobine (1) selon l'une quelconque des revendications 1 à 3, **caractérisée en ce que** l'enroulement de bobine (1w) est entouré d'une gaine extérieure (10).

5. Bobine (1) selon la revendication 4, **caractérisée en ce que** la gaine extérieure (10) est une gaine thermorétractable.

6. Bobine (1) selon l'une quelconque des revendications 4 ou 5, **caractérisée en ce que** la gaine extérieure (10) se compose d'une matière électriquement isolante.

7. Bobine (1) selon l'une quelconque des revendications 1 à 6, **caractérisée en ce qu'**elle peut être chaussée sur un mandrin creux (12) fixé sur le support de circuits (2).

8. Bobine (1) selon l'une quelconque des revendications 1 à 7, **caractérisée en ce que** le fil de raccordement (6) pour l'extrémité supérieure de la bobine (1t) est logé sensiblement par emboîtement dans l'alésage longitudinal (11) du corps de bobine (9).
